Europäisches Patentamt

European Patent Office

Office européen des brevets

(19)

(11) **EP 0 557 711 B1**

(12) **EUROPÄISCHE PATENTSCHRIFT**

(45) Veröffentlichungstag und Bekanntmachung des Hinweises auf die Patenterteilung:
**29.10.1997   Patentblatt 1997/44**

(51) Int Cl.$^6$: **G01R 33/56**

(21) Anmeldenummer: **93100770.2**

(22) Anmeldetag: **20.01.1993**

(54) **Verfahren zur Erzeugung von NMR-Signalen mit kohärentem Phasenprofil durch Kombination von Hochfrequenzimpulsen mit inkohärentem Phasenprofil**

Method for generating coherent phase profile NMR signals through combined RF impulses with incoherent phase profiles

Procédé de génération de signaux RMN ayant un profil de phase cohérente par combinaison d'impulsions à haute fréquence à profil de phase incohérente

(84) Benannte Vertragsstaaten:
**CH FR GB LI**

(30) Priorität: **26.02.1992  DE 4205780**

(43) Veröffentlichungstag der Anmeldung:
**01.09.1993   Patentblatt 1993/35**

(73) Patentinhaber: **SPECTROSPIN AG**
**CH-8117 Fällanden (CH)**

(72) Erfinder: **Hennig, Jürgen, Dr.**
**W-7800 Freiburg (DE)**

(74) Vertreter: **KOHLER SCHMID + PARTNER**
**Patentanwälte**
**Ruppmannstrasse 27**
**70565 Stuttgart (DE)**

(56) Entgegenhaltungen:
EP-A- 0 098 479      EP-A- 0 145 277
EP-A- 0 209 375      EP-A- 0 357 100
DE-A- 3 636 251

- **BERICHTE DER BUNSEN-GESELLSCHAFT FUR PHYSIKALISCHE CHEMIE Bd. 91, 1. November 1987, WEINHEIM DE Seiten 1115 - 1123 H. ARMITAGE ET AL. 'FORTSCHRITTE IN DER 2D-NMR-SPEKTROSKOPIE MIT RAUSCHANREGUNG'**
- **Magn. Res.Med. vol. 21, 251-263 (1991) Y. Zur et al.**

**Beschreibung**

Die Erfindung betrifft ein Verfahren zur Erzeugung von Kernspinresonanz (NMR)-Signalen aus einem Meßvolumen mit Probenmaterie, welches einem stationären Magnetfeld $B_0$ ausgesetzt ist, durch Einstrahlen einer Sequenz von mindestens zwei Hochfrequenz (HF)-Impulsen in das Meßvolumen, wobei die mindestens zwei HF-Impulse in einem begrenzten Frequenzband Kernspins der Probenmaterie innerhalb des Meßvolumens resonant anregen.

Ein solches Verfahren ist beispielsweise bekannt aus der US-PS 4,577,152.

Sowohl in der Kernspinresonanz-Spektroskopie als auch bei den Verfahren zur NMR-Bildgebung werden für die Erzeugung von NMR-Signalen Sequenzen von HF-Impulsen in das Meßvolumen eingestrahlt, die der Anregung observabler Magnetisierung dienen und mehr als einen HF-Impuls umfassen. Bei einer einfachen konventionellen Spin-Echo-Sequenz dient beispielsweise der erste HF-Impuls der Anregung eines ersten freien Induktionszerfalles (FID) und im einfachsten Falle ein weiterer HF-Impuls der Refokussierung des FID-Signals, so daß am Ende ein Spin-Echo-Signal beobachtet werden kann. Selbstverständlich erzeugt aber auch der zweite und jeder weitere HF-Impuls einer Mehrimpuls-Sequenz für sich jeweils ein FID-Signal. Da in der Regel nur das Spin-Echo-Signal beobachtet werden soll, sind in diesem Fall sämtliche FID-Signale Störgrößen, die zur eigentlichen Meßgröße nicht nur nichts beitragen, sondern gelegentlich sogar destruktiv mit ihr interferieren.

Das gleiche Problem tritt prinzipiell bei allen Mehr-Impuls-Sequenzen auf, die in ihrer Kombination ein bestimmtes Meßsignal erzeugen sollen, daneben aber auch zwangsläufig eine Vielzahl von störenden weiteren NMR-Signalen hervorrufen.

Aus Y. Zur et al.: "Spoiling of Transverse Magnetization in Steady-State Sequences"; Magn. Res. Med 21, 251-263 (1991) ist ein Verfahren bekannt, bei dem die Phase von HF-Puls zu HF-Puls inkrementiert wird, wobei keine Verschlüsselung der Phase vorgenommen wird. Damit sollen unerwünschte Signale der transversalen Magnetisierung eliminiert oder unterdrückt werden.

Aufgabe der vorliegenden Erfindung ist es, ein Verfahren der eingangs genannten Art vorzustellen, bei dem die unerwünschten Signale, die bei Mehrimpuls-Anregungen stets auch mitentstehen, nach Belieben unterdrückt werden können.

Diese Aufgabe wird erfindungsgemäß dadurch gelöst, daß die Phase des ersten HF-Impulses in Abhängigkeit von seiner Frequenz so gewählt wird, daß die Phase des von diesem HF-Impuls erzeugten NMR-Signals derart randomisiert ist, daß die vektorielle Summe über die von diesem HF-Impuls erzeugte transversale Magnetisierung Null ist, und daß die Phase jedes weiteren HF-Impulses in Abhängigkeit von der Phase des ersten Impulses so gewählt ist, daß die Vektorsumme über die von jedem dieser weiteren HF-Impulse erzeugte transversale Magnetisierung ebenfalls Null ist, und daß die Kombination der mindestens zwei HF-Impulse zur Ausbildung beobachtbarer kohärenter Magnetisierung der Probenmaterie führt.

Die Wahl eines randomisierten, d.h. durch eine Pseudorandomfunktion definiert verschlüsselten Phasenprofils der schmalbandigen Anregungsimpulse bewirkt, daß die FID-Signale, die von den Einzelimpulsen hervorgerufen werden, Signalintensitäten mit inkohärenten Phasen aufweisen, die nicht beobachtbar sind. Durch entsprechende Phasenwahl bei den Anregungsimpulsen kann jedoch das definierte randomisierte Phasenprofil der zugehörigen NMR-Signale so gestaltet werden, daß die Kombinationssignale, die nur durch das Zusammenwirken mehrerer Impulse der Anregungssequenz zustandekommen, eine kohärente und damit beobachtbare Magnetisierung der Probenmaterie im Meßvolumen wiederspiegeln. Dadurch können beispielsweise Gradientenschaltungen eingespart werden, die sonst zur Selektion bestimmter erwünschter Signale und zur Unterdrückung der übrigen, unerwünschten Signale notwendig wären.

Bei einer Ausführungsform der Erfindung ist die Sequenz von mindestens zwei HF-Impulsen eine Spinecho-Sequenz für die NMR-Bildgebung, bei der während des Anliegens eines Scheibenselektionsgradienten zunächst ein HF-Impuls in das Meßvolumen eingestrahlt wird, welcher in der Probenmaterie eine gleichmäßige Verteilung von Magnetisierungen in Richtung des Scheibenselektionsgradienten anregt, wobei diese Magnetisierung dann durch einen weiteren HF-Impuls zur Ausbildung eines Spin-Echos refokussiert wird, welches schließlich von einem Phasenkodiergradienten ortskodiert und während des Anliegens eines Lesegradienten ausgelesen wird, und wobei die Phasen der HF-Impulse so gewählt werden, daß sie lediglich zur Bildung eines Spin-Echos, nicht jedoch zur Ausbildung der freien Induktionszerfälle (FID) führen, die durch den anregenden HF-Impuls und den refokussierenden HF-Impuls allein erzeugt werden würden.

Neben der konventionellen Spin-Echo-Sequenz kann für die NMR-Bildgebung bei einer weiteren Ausführungsform der Erfindung auch eine Multislice-Multiecho-Impulssequenz Anwendung finden.

Bei einer bevorzugten Ausführungsform des erfindungsgemäßen Verfahrens in der volumenselektiven Spektroskopie wird in drei aufeinanderfolgenden Scheibenselektionsschritten jeweils ein HF-Impuls während des Anliegens eines von drei Scheibenselektionsgradienten in das Meßvolumen eingestrahlt, wobei jeder der drei verwendeten Scheibenselektionsgradienten auf den beiden anderen senkrecht steht, so daß ein Spin-Echo aus den durch den ersten HF-Impuls angeregten und den durch die beiden folgenden HF-Impulse refokussierten Magnetisierungen erzeugt wird, welches aufgrund der Scheibenselektivität in jeder der drei Gradientenrichtungen aus dem Überschneidungsvolumen der drei selektierten Scheiben stammt, und die Phase von wenigstens einem der drei HF-Impulse - vorzugsweise dem der Datenaufnahme unmittelbar vorangehenden - wird so gewählt, daß die Phasen der erzeugten NMR-Signale randomisiert werden, wonach mit einem weiteren in geeigneter Weise phasenmodulierten Impuls das Signal des gewünschten Spin-Echos ausgelesen werden kann, während die unerwünschten NMR-Signale dephasiert und damit nicht beobachtbar sind. Andere Verfahren zur volumenselektiven Spektroskopie, bei denen jedoch von der Randomisierung der Phasen der erzeugten NMR-Signale kein Gebrauch gemacht wird, sind beispielsweise aus der US-PS 4,480,228 bekannt.

Statt der Bevorzugung des Spin-Echo-Signals kann schließlich bei einer anderen Ausführungsform des erfindungsgemäßen Verfahrens im Rahmen der volumenselektiven Spektroskopie auch das stimulierte Echo-Signal bevorzugt werden, während das Spin-Echo-Signal unterdrückt wird.

In diesem Fall wird in drei aufeinanderfolgenden Scheibenselektionsschritten jeweils ein HF-Impuls während des Anliegens eines von drei Scheibenselektionsgradienten in das Meßvolumen eingestrahlt, wobei jeder der drei verwendeten Scheibenselektionsgradienten auf den beiden anderen senkrecht steht, so daß durch die beiden letzten HF-Impulse ein stimuliertes Echo aus den durch den ersten HF-Impuls angeregten Magnetisierungen erzeugt wird, welches aufgrund der Scheibenselektivität in jeder der drei Gradientenrichtungen aus dem Überschneidungsvolumen der drei selektierten Scheiben stammt, und die Phasen der drei HF-Impulse werden so gewählt, daß aufgrund der Randomisierung der Phasen der erzeugten NMR-Signale lediglich das stimulierte Echo-Signal zu beobachtbarer kohärenter Magnetisierung der Probenmaterie führt, während die anderen erzeugten NMR-Signale nicht beobachtbar sind.

Die Erfindung wird im folgenden anhand der in der Zeichnung dargestellten Ausführungsbeispiele näher beschrieben und erläutert. Die der Beschreibung und der Zeichnung zu entnehmenden Merkmale können bei anderen Ausführungsformen der Erfindung einzeln, für sich oder zu mehreren in beliebiger Kombination Anwendung finden. Es zeigen:

Fig.1    ein Schema einer Impulssequenz zur Erzeugung eines Spin-Echos mit Hilfe eines Anregungsimpulses sowie eines Refokussierungsimpulses, welche unter Anwesenheit eines Magnetfeldgradienten $G_s$ angewandt werden;

Fig.2    ein Schema einer Sequenz von "weißen" Impulsen zur Erzeugung eines kohärenten Spin-Echos.

Die Erfindung beinhaltet eine Art von Hochfrequenzimpulsen für die NMR Spektroskopie und Kernspintomographie, deren Anregungsprofil zum einen schmalbandig ist, so daß sie zur Anregung von Spins innerhalb eines begrenzten Frequenz-bereichs verwendet werden können. Zum anderen besteht die wesentliche Eigenschaft dieser Impulse darin, daß die Phase der durch diese Impulse angeregten transversalen Magnetisierung in Abhängigkeit von der Anregungsfrequenz - das sogenannte Phasenprofil - randomisiert, d.h. durch eine Pseudorandomfunktion definiert verschlüsselt ist, so daß die vektorielle Summe über das Anregungsprofil gleich Null wird. Solche Impulse werden im folgenden "weiße Impulse" genannt. Wird das von solchen Impulsen erzeugte Signal so ausgelesen, daß zwischen den Magnetisierungen, welche während des Impulses mit unterschiedlichen Larmorfrequenzen präzedierten, zum Zeitpunkt des Datenauslesens nicht unterschieden wird, so zeigt das erzeugte Signal eine Intensität Null, das heißt, obwohl transversale Magnetisierung angeregt wurde, wird kein observables Signal erzeugt.

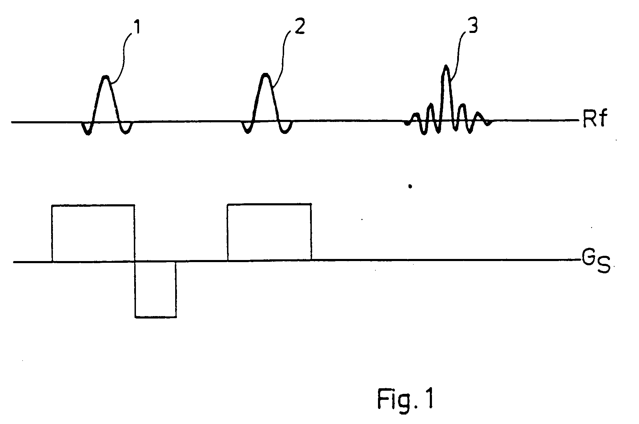

Ein typischer Fall ist die Verwendung von scheibenselektiven Impulsen, bei welchen zum Zeitpunkt des Impulses ein Magnetfeldgradient anwesend ist, dieser Gradient jedoch zum Zeitpunkt des Auslesens nicht mehr vorhanden ist. Ein Beispiel für eine solche scheibenselektive Impulssequenz ist in Fig. 1 gezeigt, wo in Anwesenheit des Scheibenselektionsgradienten $G_S$ zunächst ein Anregungsimpuls 1 und später ein Refokussierungsimpuls 2 in das Meßvolumen eingestrahlt wird, um ein Spin-Echo 3 zu erzeugen.

Meßsequenzen, welche zwei oder mehrere Impulse erfordern (wie z.B. eine Spin-Echo-Sequenz), führen zur Ausbildung von mehreren Signalen. Bei zwei Impulsen ist dies der freie Induktionszerfall aus jedem einzelnen Impuls sowie das eigentliche Spin-Echo. Bei Verwendung von weißen Impulsen läßt sich dann das Phasenprofil jedes Impulses so gestalten, daß nur ein einziges aus der Vielzahl möglicher Signale erzeugt wird. Im folgenden wird das Wesen solcher Impulse am Beispiel einer Spin-Echo-Sequenz zur Erzeugung eines schichtselektiven Bildes in der Kernspintomographie erklärt.

Eine Spin-Echo-Sequenz besteht aus einer Folge von zwei Hochfrequenzimpulsen. Prinzipiell werden von zwei Impulsen drei Signale erzeugt, nämlich je ein freier Induktionszerfall (FID) von jedem Impuls sowie das Spin-Echo. Die Phase φ jedes dieser Signale hängt dabei von der Phase des Impulses für die jeweilige Beobachtungsfrequenz ω ab. Dabei gilt:

$$\varphi_{FID1} = \alpha_1(\omega) + 90° \tag{1}$$

$$\varphi_{FID2} = \alpha_2(\omega) + 90° \qquad (2)$$

$$\varphi_{SE} = 2 \cdot \alpha_2(\omega) - (\alpha_1(\omega) + 90°), \qquad (3)$$

wobei $\varphi_{FID1}$ und $\varphi_{FID2}$ die Phasen der beiden FID bezeichnet, $\varphi_{SE}$ diejenige des Spin-Echos, $\alpha_1(\omega)$ die Phase des ersten Impulses für die Frequenz $\omega$ und $\alpha_2(\omega)$ die Phase des zweiten Impulses für die Frequenz $\omega$.

Ziel ist es nun, $\varphi_{SE}$ innerhalb der Anregungsbandbreite unabhängig von $\omega$ zu gestalten, so daß die erzeugten Signale unterschiedlicher Frequenz sich kohärent zu einem Signal der Phase $\gamma$ addieren, wobei gleichzeitig $\alpha_1(\omega)$ und $\alpha_2(\omega)$ so gewählt werden, daß das Phasenprofil jedes Impulses randomisiert ist und damit die Intensität der beiden FID bei homogener Verteilung der Magnetisierung über die Anregungsbandbreite gleich Null wird.

Aus (1), (2) und (3) folgt dann unmittelbar

$$\alpha_2(\omega) = (\gamma + \alpha_1(\omega) + 90°)/2. \qquad (4)$$

Erzeugt man also einen Impuls mit einer randomisierten Phase $\alpha_1(\omega)$ und einen zweiten Impuls der Phase $\alpha_2(\omega)$ nach Gleichung (4), so läßt sich damit ein Spin-Echo-Signal derselben Intensität erzielen wie bei der Verwendung von konventionellen Impulsen, deren Anregungsprofil keine randomisierte Phase, jedoch dieselbe Amplitude $A_1(\omega)$ und $A_2(\omega)$ aufweist. Die Intensitäten der jeweiligen FID werden jedoch in Gegensatz zur Verwendung konventioneller Impulse gleich Null sein.

Anwendungen lassen sich für solche Impulse überall finden, wo konventionelle Methoden zur Beseitigung unerwünschter Signale entweder nicht ausreichend sind oder unangebracht erscheinen. Bisher bekannte Verfahren zu diesem Zweck verwenden zum einen zusätzliche Gradienten, welche eine Refokussierung nur des gewünschten Signals erzwingen, nicht jedoch der unerwünschten Signale. Für den Fall des obigen Spin-Echo-Experimentes ist dies zum Beispiel durch zwei Gradienten symmetrisch um den zweiten Impuls erfüllt. Werden zur Verbesserung des Signal-zu-Rausch Verhältnisses mehrere Signale unter Wiederholung des Experimentes aufaddiert, so können auch Phasenzyklen der Referenzphase beider Impulse zur Selektion des erwünschten Signales angewendet werden.

Die erste Möglichkeit ist dann nicht anwendbar, wenn zum Beispiel das Timing der Meßsequenz die Anwendung von Zusatzgradienten nicht zuläßt, wie zum Beispiel bei Spin-Echo-Sequenzen mit möglichst kurzen Echozeiten. Bei Sequenzen, welche eine wiederholte Anregung erfordern (MR-Imaging, n-dimensionale Fourier Transform Experimente), tritt außerdem ein Refokussierungseffekt ein, welcher das Auftauchen von Folgesignalen in späteren Aufnahmezyklen bewirkt. Auch bei volumenselektiver Spektroskopie verbietet sich wegen der mit zusätzlichen Gradientenschaltvorgängen verbundenen Wirbelströme oft die Anwendung von Zusatzgradienten.

Bei Verwendung von weißen Impulsen für eine beliebige Meßsequenz mit n Impulsen läßt sich für die Phase aller relevanten Signale ein Gleichungssystem entsprechend (1) bis (3) aufstellen. Bei freier Wahl der randomisierten Phasenprofile $\alpha_1(\omega)...\alpha_{n-1}(\omega)$ für n-1 Impulse läßt sich dann das Phasenprofil $\alpha_n(\omega)$ des n-ten Impulses so berechnen, daß das gewünschte Signal eine kohärente Phase $\gamma$ besitzt.

Das Prinzip dieser Vorgehensweise läßt sich so umschreiben, daß sämtliche Signale von n-1 Pulsen zunächst "verschlüsselt" erzeugt werden und zu keiner beobachtbaren Magnetisierung führen. Der n-te Impuls enthält dann in seinem Phasenprofil den Schlüssel zur Dekodierung des gewünschten Signals, wobei alle anderen Signale weiterhin verschlüsselt bleiben.

Neben den schon erwähnten Anwendungen aus der MR-Tomographie (schnelle Spin-Echo-Sequenz, volumenselektive Spektroskopie) soll erwähnt werden, daß weiße Impulse auch bei solchen Experimenten verwendet werden können, bei welchen keine räumliche Auflösung erwünscht ist. So läßt sich im einfachsten Fall eine Spin-Echo-Sequenz für die NMR-Spektroskopie wie in Fig.1 gezeigt aufbauen, bei welcher die Gradienten $G_s$ unter den Impulsen 1,2 nur den Zweck haben, eine gleichmäßige Verteilung der Magnetisierungen unter dem Anregungsimpuls 1 zu erzielen. Die eigentliche Datenaufnahme des Spin-Echos 3 erfolgt dann jedoch ohne Gradient, so daß ein NMR-Spektrum aufgenommen wird. Die Stärke des Gradienten und die spektrale Breite des Anregungsprofils sind dann so zu wählen, daß die selektierte Scheibe die gesamte Probe umfaßt.

Anwendungen weißer Impulse für komplexere Multiimpuls-Experimente wie etwa n-dimensionale Fourier-Transform-Experimente sind dem Fachmann aus der obigen Beschreibung ohne weiteres erschließbar und werden daher hier nicht im Detail beschrieben.

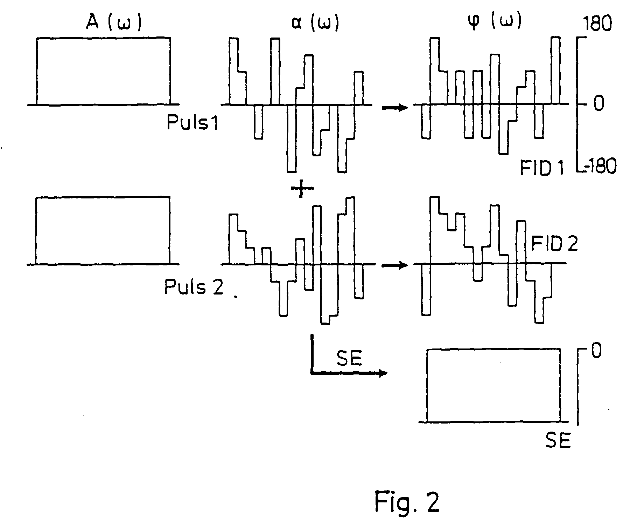

Fig. 2 zeigt ein Beispiel für die erfindungsgemäße Verwendung von weißen Impulsen zur Erzeugung eine kohärenten Spin-Echos. Die erste Zeile gibt links idealisiert die Anregungsamplitude $A_1(\omega)$ des Impulses 1 wieder, der als Anregungsimpuls fungiert, die mittlere Spalte zeigt das Phasenprofil $\alpha_1(\omega)$ dieses Impulses und die rechte Spalte das

Phasenprofil $\varphi_1(\omega)$ der dadurch zu einem freien Induktionszerfall (FID1) angeregten transversalen Magnetisierung. In der zweiten Zeile sind Anregungsprofil $A_2(\omega)$, Phasenprofil $\alpha_2(\omega)$ bzw. $\varphi_2(\omega)$ des Impulses 2 sowie des nachfolgenden FID2 für den Refokussierungsimpuls dargestellt. Die letzte Zeile zeigt, daß das Phasenprofil des durch beide Impulse erzeugten Spin-Echos SE kohärent ist und zu beobachtbarer transversaler Magnetisierung führt, wohingegen das Phasenprofil von FID1 und FID2 zeigt, daß die Magnetisierungen dephasiert vorliegen.

Im folgenden wird ein Verfahren zur Erzeugung randomisierter Impulse beschrieben.

Phasenmodulierte Hochfrequenzimpulse, welche ein diskretes Band von Anregungsfrequenzen mit innerhalb des schmalbandigen Anregungsbereichs möglichst gleicher Amplitude, jedoch in Abhängigkeit von der Meßsequenz randomisierter Phase erzeugen, werden allgemein in diskreter Form erzeugt, daß heißt, der Impuls wird als zeitliche Abfolge eines diskreten Rasters eines HF-Feldes $B_1$ mit definierter Phase und Amplitude beschrieben.

Für die zeitliche Entwicklung der durch die longitudinale Magnetisierung $M_z$ sowie die transversalen Magnetisierungen $M_x$ und $M_y$ beschriebenen Gesamtmagnetisierung in einem durch die Komponenten $B_{1x}(t)$ und $B_{1y}(t)$ beschriebenen zeitlich veränderlichen Hochfrequenzimpuls gelten die Blochschen Gleichungen:

$$dM_z/dt = - M_y \cdot \gamma \cdot B_{1x}(t) + M_x \cdot \gamma \cdot B_{1y}(t) - (M_o - M_z)/T_1 \tag{5}$$

$$dM_y/dt = M_z \cdot \gamma \cdot B_{1x}(t) - M_x \cdot \gamma \cdot \omega - M_y/T_2 \tag{6}$$

$$dM_x/dt = - M_z \cdot \gamma \cdot B_{1y}(t) + M_y \cdot \gamma \cdot \omega - M_x/T_2 \tag{7}$$

wobei die jeweils letzten Terme, welche die Relaxation beschreiben, im allgemeinen nicht berücksichtigt werden, da die Gesamtdauer des Impulses kurz im Vergleich zu den Relaxationszeiten ist.

Für die Amplitude I(t) des Hochfrequenzimpulses gilt dann

$$I(t)^2 = B_{1x}(t) + B_{1y}(t), \tag{8}$$

für die Phase $\psi(t)$ gilt

$$\tan(\psi/t) = B_{1x}(t)/B_{1y}(t) \tag{9}$$

Die Anregungsamplitude $A(\omega)$ und das Phasenprofil $\alpha(\omega)$ der angeregten Magnetisierungen ergibt sich dann durch numerische Intergration der Gleichungen (5) bis (7) über die Dauer des Impulses.

Formal lassen sich I(t) und $\psi(t)$ folglich durch Inversion der numerischen Berechnung für ein Profil $A(\omega)=const.$ und $\alpha(\omega) = rand.$(randomisiert) im Intervall $\omega_1$ bis $\omega_2$, welches der Anregungsbandbreite des Impulses entsprechen soll, beschreiben. Dabei muß beachtet werden, daß auf Grund der endlichen zeitlichen Dauer des Impulses und das gewünschten diskreten Anregungsimpulses eine solche Lösung nur als Näherung erreicht werden kann, da aus der Signaltheorie folgt, daß diskrete Impulse in der Zeit- oder Frequenzdomäne exakt immer unendlich ausgedehnte Profile in der jeweils anderen Domäne bewirken.

In der Literatur sind sehr viele Algorithmen beschrieben, wie die näherungsweise Berechnung durchgeführt werden kann. Diese Algorithmen verwenden unterschiedliche Arten der Beschreibung der Impulse ("time-domain-" oder "Fourier component-presentation") sowie unterschiedliche Strategien und Optimierungsbedingungen zur iterativen oder nicht-iterativen Anpassung an ein vorgegebenes Anregungsprofil $A(\omega)$, $\alpha(\omega)$.

Auf die jeweiligen Vor- und Nachteile der einzelnen Methoden soll hier nicht näher eingegangen werden; sie sind dem Fachmann bekannt und ohne weiteres nachvollziehbar.

Eine sehr einfache und praktikable Art der Erzeugung von Impulsen, die obigem Kriterium genügen, besteht in der Anwendung des Superpositionsprinzips. Der Impuls mit dem Anregungsprofil von $\omega_1$ bis $\omega_n$ wird hierbei beschrieben durch eine Überlagerung von Einzelimpulsen, welche jeweils ein unterschiedliches diskretes Anregungsprofil mit jeweils unterschiedlicher Phase aufweisen, so daß das Gesamtprofil beschrieben werden kann als:

$$A(\omega_1,\omega_n)=A_1(\omega_1,\omega_2)+A_2(\omega_2,\omega_3)+A_3(\omega_3,\omega_4)... A_{n-1}(\omega_{n-1},\omega_n) \tag{10}$$

und

$$\alpha(\omega_1,\omega_n)=\alpha_1(\omega_1,\omega_2)+\alpha_2(\omega_2,\omega_3)+\alpha_3(\omega_3,\omega_4)...\alpha_{n-1}(\omega_{n-1},\omega_n) \qquad (11)$$

Nimmt man als Profil der Teilimpulse $A_{m-1}(\omega_{m-1},\omega_m)$, $\alpha_{m-1}(\omega_{m-1},\omega_m)$ Impulse mit einem optimierten Rechteckprofil, wie sie in der Literatur beschrieben sind und die durch einen zeitlich begrenztes $B_1$-Feld $I(t)$, $\psi(t)$ beschrieben werden können, so läßt sich durch Variation der Phase $\psi(t)$ der jeweiligen Teilimpulse um eine für den jeweiligen Einzelimpuls konstante, jedoch von Einzelimpuls zu Einzelimpuls randomisierte Phasenänderung $\Delta\psi(t)$ nach Gl.(10) und (11) bei Verwendung einer genügenden Anzahl von Einzelimpulsen (typischerweise > 10) ein Impuls erzeugen, welcher zum Einsatz bei dem erfindungsgemäßen Verfahren hinreichend gut geeignet ist.

Die zur Erreichung der Erzeugung eines einzelnen aus der Vielzahl aller von einer Folge von Impulsen erzeugten Signals benötigten Phasenprofile der anderen Impulse lassen sich dann unter Verwendung von Gl.(4) oder einer für das betreffende Problem analogen Gleichung ebenfalls durch Impulse nach dem Superpositionsprinzip erzeugen.

## Patentansprüche

1. Verfahren zur Erzeugung von Kernspinresonanz (NMR)-Signalen aus einem Meßvolumen mit Probenmaterie, welches einem stationären Magnetfeld $B_0$ ausgesetzt ist, durch Einstrahlen einer Sequenz von mindestens zwei Hochfrequenz (HF)-Impulsen in das Meßvolumen, wobei die mindestens zwei HF-Impulse in einem begrenzten Frequenzband Kernspins der Probenmaterie innerhalb des Meßvolumens resonant anregen,
dadurch gekennzeichnet,
daß die Phase des ersten HF-Impulses in Abhängigkeit von seiner Frequenz so gewählt wird, daß die Phase des von diesem HF-Impuls erzeugten NMR-Signals derart randomisiert ist, daß die vektorielle Summe über die von diesem HF-Impuls erzeugte transversale Magnetisierung Null ist, und die Phase jedes weiteren HF-Impulses in Abhängigkeit von der Phase des ersten Impulses so gewählt ist, daß die Vektorsumme über die von jedem dieser weiteren HF-Impulse erzeugte transversale Magnetisierung ebenfalls Null ist, und daß die Kombination der mindestens zwei HF-Impulse zur Ausbildung beobachtbarer kohärenter Magnetisierung der Probenmaterie führt.

2. Verfahren nach Anspruch 1, dadurch gekennzeichnet, daß die Sequenz von mindestens zwei HF-Impulsen eine Spin-echo-Sequenz für die NMR-Bildgebung ist, wobei während des Anliegens eines Scheibenselektionsgradienten zunächst ein HF-Impuls in das Meßvolumen eingestrahlt wird, welcher in der Probenmaterie eine gleichmäßige Verteilung von Magnetisierungen in Richtung des Scheibenselektionsgradienten anregt, wobei diese Magnetisierung dann durch einen weiteren HF-Impuls zur Ausbildung eines Spin-Echos refokussiert wird, welches schließlich von einem Phasenkodiergradienten ortskodiert und während des Anliegens eines Lesegradienten ausgelesen wird, und wobei die Phasen der HF-Impulse so gewählt werden, daß sie lediglich zur Bildung eines Spin-Echos, nicht jedoch zur Ausbildung der freien Induktionszerfälle (FID) führen, die durch den anregenden HF-Impuls und den refokussierenden HF-Impuls allein erzeugt werden würden.

3. Verfahren nach Anspruch 2, dadurch gekennzeichnet, daß die Sequenz eine Multislice-Multiecho-Sequenz ist.

4. Verfahren nach Anspruch 1, dadurch gekennzeichnet, daß in drei aufeinanderfolgenden Scheibenselektionsschritten jeweils ein HF-Impuls während des Anliegens eines von drei Scheibenselektionsgradienten in das Meßvolumen eingestrahlt wird, wobei jeder der drei verwendeten Scheibenselektionsgradienten auf den beiden anderen senkrecht steht, so daß ein Spin-Echo aus den durch den ersten HF-Impuls angeregten und den durch die beiden folgenden HF-Impulse refokussierten Magnetisierungen erzeugt wird, welches aufgrund der Scheibenselektivität in jeder der drei Gradientenrichtungen aus dem Überschneidungsvolumen der drei selektierten Scheiben stammt, und daß die Phase von wenigstens einem der drei HF-Impulse so gewählt wird, daß mehrere oder alle der insgesamt erzeugten NMR-Signale dephasiert vorliegen und durch weiteres Anlegen von phasenmodulierten Impulsen im Sinne des Anspruchs 1 lediglich das gewünschte Signal zu kohärenter Magnetisierung führt, während die anderen erzeugten NMR-Signale nicht beobachtbar sind.

5. Verfahren nach Anspruch 1, dadurch gekennzeichnet, daß in drei aufeinanderfolgenden Scheibenselektionsschritten jeweils ein HF-Impuls während des Anliegens eines von drei Scheibenselektionsgradienten in das Meßvolumen eingestrahlt wird, wobei jeder der drei verwendeten Scheibenselektionsgradienten auf den beiden anderen senkrecht steht, so daß durch die beiden letzten HF-Impulse ein stimuliertes Echo aus den durch den ersten HF-Impuls angeregten Magnetisierungen erzeugt wird, welches aufgrund der Scheibenselektivität in jeder der drei Gradientenrichtungen aus dem Überschneidungsvolumen der drei selektierten Scheiben stammt, und daß die Phasen der drei HF-Impulse so gewählt werden, daß aufgrund der Randomisierung der Phasen der erzeugten NMR-Signale lediglich das stimulierte Echo-Signal zu beobachtbarer kohärenter Magnetisierung der Probenmaterie führt, während die anderen erzeugten NMR-Signale nicht beobachtbar sind.

## Claims

1. Method for the generation of nuclear magnetic resonance (NMR) signals from a measuring volume with test substance, which is exposed to a stationary magnetic field $B_0$, by irradiation of a sequence of at least two radio frequency (RF)-pulses into the measuring volume, wherein the at least two RF-pulses excite nuclear spins of the test substance within the measuring volume in a resonant manner within a limited frequency band, characterised in that, the phase of the first RF-pulse is selected in dependence upon its frequency in such a manner that the phase of the NMR-signal generated by said RF-pulse is randomised in such a manner that the vectorial sum over the transverse magnetization generated by said rf pulse equals zero, and that the phase of each further rf pulse is selected in dependence upon the phase of the first pulse in such a manner that the vectorial sum over the transverse magnetization generated by each of said further rf pulses also equals zero, and that the combination of the at least two RF-pulses leads to the formation of observable coherent magnetization of the test substance.

2. Method according to claim 1, characterised in that the sequence of at least two RF-pulses is a spin echo sequence for the NMR-imaging, wherein during the presence of a slice selection gradient firstly an RF-pulse is irradiated into the measuring volume which causes a uniform distribution of magnetizations in the direction of the slice selection gradient in the test substance, wherein this magnetization is then refocussed by means of a further RF-pulse in order to form a spin echo which is finally spatially encoded by a phase encoding gradient and is read during the presence of a read gradient, and wherein the phases of the RF-pulses are selected such that they merely lead to the formation of a spin echo, but not to the formation of the free induction decays (FID) which would be generated by the exciting rf pulse and the refocussing rf pulse only.

3. Method according to claim 2, characterised in that the sequence is a multi-slice multi-echo sequence.

4. Method according to claim 1, characterised in that in three consecutive slice selection steps one RF-pulse in each case is irradiated into the measuring volume during the presence of one of three slice selection gradients, wherein each of the three used slice selection gradients is perpendicular to the two others such that a spin echo is generated from the magnetizations which are excited by the first RF-pulse and refocussed by the two following RF-pulses and is derived from the intersection volume of the three selected slices owing to the slice selectivity in each of the three gradient directions and that the phase of at least one of the three RF-pulses is selected such that several or all of the total of the generated NMR-signals exist in a dephased manner and due to the further application of phase-modulated pulses according to claim 1 merely the wanted signal leads to a coherent magnetization, whereas the other generated NMR signals are not observable.

5. Method according to claim 1, characterised in that in three consecutive slice selection steps one RF-pulse in each case is irradiated into the measuring volume during the presence of one of three slice selection gradients, wherein each of the three used slice selection gradients is perpendicular to the other two such that due to the two last RF-pulses a stimulated echo is generated from the magnetizations excited by the first RF-pulse which is derived from the intersection volume of the three selected slices in each of the three gradient directions owing to the slice selectivity and that the phases of the three RF-pulses are selected such that, owing to the randomization of the phases of the generated NMR signals, merely the stimulated echo signal leads to an observable coherent magnetization of the test substance, whereas the other generated NMR signals are not observable.

## Revendications

1. Procédé de génération de signaux de résonance de spin nucléaire [de résonance magnétique nucléaire, RMN] à partir d'un volume de mesure contenant de la matière d'essai, laquelle est exposée à un champ magnétique stationnaire $B_0$, par irradiation du volume de mesure par une séquence d'au moins deux impulsions à haute fréquence (HF), et les au moins deux impulsions à haute fréquence excitant par résonance à l'intérieur du volume,dans une bande de fréquences limitée, le spin de la matière d'essai, procédé caractérisé en ce que la phase de la première impulsion à haute fréquence est choisie en fonction de sa fréquence, de manière que le signal RMN engendré soit rendu aléatoire de façon que la somme vectorielle de l'aimantation transversale de cette impulsion à haute fréquence soit nulle, et que la phase de chaque autre impulsion à haute fréquence soit choisie, en fonction de la phase de la première impulsion, de manière que l'aimantation transversale engendrée à l'aide de chacune de ces autres impulsions HF soit également nulle, et que la combinaison des au moins deux impulsions à haute fréquence conduise à la formation d'une aimantation cohérente observable de la matière d'essai.

2. Procédé selon la revendication 1, caractérisé en ce que la séquence d'au moins deux impulsions HF est une séquence d'écho de spin pour la formation d'une image ou spectre de RMN, procédé selon lequel, pendant l'application d'un gradient de sélection de tranches, le volume d'essai est tout d'abord irradié par une impulsion HF, qui, dans la matière d'essai, excite une répartition uniforme des aimantations dans la direction du gradient de sélection des tranches, de sorte que cette aimantation soit ensuite refocalisée par une autre impulsion HF pour la formation d'un écho de spin, qui est finalement codé localement par un gradient de codage de phase et, pendant l'application d'un gradient de lecture est lu, et de manière que les phases des impulsions HF soient choisies de manière qu'elles conduisent tout simplement à la formation d'un écho de spin et non pas à la formation de ruptures libres d'induction qui seraient engendrées uniquement par l'impulsion HF excitatrice et par l'impulsion HF de refocalisation.

3. Procédé selon la revendication 2, caractérisé en ce que la séquence est une séquence multitranches-multiéchos.

4. Procédé selon la revendication 1, caractérisé en ce que, dans trois étapes successives de sélection de tranches, le volume de mesure est irradié à chaque fois par une impulsion HF pendant l'application de trois gradients de sélection de tranches, chacun des trois gradients de sélection des tranches que l'on utilise étant perpendiculaire aux deux autres, de sorte qu'est engendré un écho de spin provenant des aimantations excitées par la première impulsion HF et de l'aimantation refocalisée par les deux impulsions suivantes, aimantation qui provient, en raison de la sélectivité des tranches dans chacune des trois directions de gradient du volume de surcoupe des trois tranches choisies, et de façon que la phase d'au moins l'une des trois impulsions HF soit choisie de manière que plusieurs ou tous les signaux de RMN engendrés au total soient déphasés et, grâce à la poursuite de l'application d'impulsions à modulation de phase au sens de la revendication 1, le signal voulu conduise tout simplement à une aimantation cohérente, cependant que les autres signaux de RMN engendrés ne soient pas observables.

5. Procédé selon la revendication 1, caractérisé en ce que, dans d'autres étapes successives de sélection de tranches, le volume de mesure est irradié à chaque fois par une impulsion HF pendant l'application d'un des trois gradients de sélection de tranches, chacun des trois gradients de sélection des tranches que l'on utilise étant perpendiculaire aux deux autres, de sorte, que, par les deux dernières impulsions HF soit engendré un écho stimulé des aimantations excitées par la première impulsion HF, lequel provient, en raison de la sélectivité des tranches dans chacune des trois directions de gradient, du volume de surcoupe des trois tranches choisies, et que les phases des trois impulsions HF soient choisies de manière qu'en raison de l'aléation des phases des signaux RMN engendrés, le signal d'écho stimulé conduise tout simplement à une aimantation cohérence observable de la matière d'essai, cependant que les autres signaux de RMN engendrés ne sont pas observables.

Fig. 1

Fig. 2